# EUROPEAN PATENT APPLICATION

(11) **EP 4 321 934 A1**
(43) Date of publication of application: **14.02.2024**
(21) Application number: 22189906.5
(22) Date of filing: 11.08.2022
(51) Int. Cl.: G03F 7/20, H05G 2/00

(54) **FLUID DISPENSING SYSTEM AND METHOD**

(71) Applicant: ASML Netherlands B.V., 5500 AH Veldhoven (NL)
(72) Inventor: HUANG, Zhuangxiong, 5500 AH Veldhoven (NL); TRALLI, Aldo, 5500 AH Veldhoven (NL); JILISEN, Reinier, Theodorus, Martinus, 5500 AH Veldhoven (NL); MERKX, Maarten, Anton, Gertruda, 5500 AH Veldhoven (NL)
(74) Representative: ASML Netherlands B.V.

(57) **Abstract**

There is provided a fluid dispensing system including a fluid-permeable surface having a pre-defined permeability to allow permeation of a fluid, and a controller configured to control the rate of permeation of the fluid into a volume by controlling one or both of a pressure of the fluid and an exposed surface area of the fluid-permeable surface. Also provided is a method of controlling the dispensing of a fluid, a plasma-generating apparatus including such a fluid dispensing system as well as the use of such a system, method, or apparatus in a lithographic apparatus or process.

## Description

### FIELD

The present invention relates to a fluid dispensing system, a method of controlling the dispensing of a fluid, a plasma generating apparatus including the fluid dispensing system, and the use of such a fluid dispensing system, method, or plasma-generating apparatus in a lithography apparatus or process. The present invention has particular, but not exclusive, application to EUV lithography.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g. a mask) onto a layer of radiation-sensitive material (resist) provided on a substrate.

The wavelength of radiation used by a lithographic apparatus to project a pattern onto a substrate determines the minimum size of features which can be formed on that substrate. A lithographic apparatus which uses EUV radiation, being electromagnetic radiation having a wavelength within the range 4-20 nm, may be used to form smaller features on a substrate than a conventional lithographic apparatus (which may for example use electromagnetic radiation with a wavelength of 193 nm).

A lithographic apparatus includes a patterning device (e.g. a mask or reticle). Radiation is provided through or reflected off the patterning device to form an image on a substrate. A membrane assembly, also referred to as a pellicle, may be provided to protect the patterning device from airborne particles and other forms of contamination. Contamination on the surface of the patterning device can cause manufacturing defects on the substrate.

Within the apparatus, there is a low pressure of gas, typically hydrogen, that can have various functions, such as cooling or cleaning. The gas is at low pressure to minimise the amount of radiation which is absorbed by the gas. Even though there is a low-pressure hydrogen environment within the apparatus, radiation, such as EUV radiation, can generate hydrogen plasma. The hydrogen plasma includes hydrogen ions and hydrogen radicals, which can interact with materials within the apparatus. This is undesirable since it can result in contamination of optical elements within the apparatus. For example, the hydrogen plasma can react with silicon to form silane. The silane is able to diffuse within the apparatus and subsequently decompose, thereby leaving silicon contamination within the apparatus. If this contamination is on an optical element, such as a mirror, a reticle, or a fiducial, this can result in a loss of throughput of the lithography apparatus.

The present invention has been devised in an attempt to address at least some of the problems identified above.

### SUMMARY OF THE INVENTION

According to a first aspect of the present disclosure, there is provided a fluid dispensing system including a fluid-permeable surface having a pre-defined permeability to allow permeation of a fluid, and a controller configured to control the rate of permeation of the fluid into a volume by controlling one or both of a pressure of the fluid and an exposed surface area of the fluid-permeable surface.

The provision of fluids, such as gases and vapours, is useful for controlling the composition of the atmosphere within a volume, such as within a lithography apparatus. For example, oxygen can be provided to the atmosphere within a lithography apparatus in order to mitigate silane generation and its corresponding impact on the optical elements within the apparatus. Even though the presence of oxygen is useful, the concentration of the oxygen must be carefully controlled as otherwise its beneficial effects will be outweighed by its negative effects, such as oxidation of optical elements. The very small amount of oxygen required is below the operating parameters of a mass flow controller. One option to overcome this problem is to dilute the gas or fluid which is being provided with a carrier gas or carrier fluid. For example, oxygen could be diluted with hydrogen or nitrogen. In this way, it is possible to provide the small amount of gas required using existing systems, such as mass flow controllers. However, this strategy has at least one significant drawback in that it requires the provision of a second gas to dilute the gas of interest. In systems that are required to operate at low pressure, the provision of additional gas is undesirable.

The system of the present disclosure overcomes this issue by controlling the amount of fluid being provided based on its permeation through a fluid-permeable surface. In particular, the rate of permeation of a fluid into a volume, such as into a lithography apparatus, can be controlled by one or both of controlling the pressure of the fluid and an exposed surface area of the fluid-permeable surface. With regards to controlling the pressure of the fluid, it will be appreciated that the fluid is in contact with the fluid-permeable surface. The rate at which the fluid is able to be provided to a volume will depend on the nature of the fluid, the nature of the fluid-permeable surface, the surface area of the fluid-permeable surface through which fluid can permeate, and the pressure differential between different sides of the fluid-permeable surface. As such, by controlling the pressure of the fluid, it is possible to increase or decrease the rate at which fluid passes through the fluid-permeable surface. Thus, if the surface area through which the fluid is being provided is kept constant, the rate at which fluid is provided to a volume is increased. In other words, the rate of permeation per unit area of the fluid-permeable surface can be controlled by controlling the pressure differential across the fluid-permeable surface. Similarly, if the exposed surface area is increased or decreased, all else being equal, the total amount of fluid permeating through the fluid-permeable surface will correspondingly increase or decrease, albeit with the fluid permeating at the same rate per unit area of the fluid-permeable surface. It will be appreciated that the rate of permeation of a fluid into a volume through a fluid-permeable surface can be controlled by adjusting one or both of the exposed surface area, i.e. the surface area in fluid connection with the volume through which fluid can be provided into the volume,

The fluid-permeable surface may be defined by a pipe or a tube. As such, the fluid dispensing system may include a pipe or tube (which can be used synonymously) containing fluid, such as a gas or a liquid. The fluid-permeable surface may therefore be at least a portion of the surface of the pipe or tube. A pipe or tube may be convenient for positioning the fluid-permeable surface in the area of a volume, such as within a lithography apparatus, in a position where the fluid which is being provided via the tube or pipe is required. For example, this could be at a position where suppression of the creation of unwanted species, such as silane, is most desired. The fluid permeable surface may be in any suitable form which allows permeation of a fluid into the volume. For example, the fluid-permeable surface may be in the form of an area of a wall which at least partially defines the volume into which fluid is to be provided.

The fluid may be selected from air, oxygen, a nitrogen oxide, hydrogen, helium, a carbon oxide, neon, argon, and water, or any combination thereof. Carbon oxide can be carbon monoxide or carbon dioxide. A nitrogen oxide can be any oxide of nitrogen, such as, for example, NO₂ or NO.

The fluid-permeable surface may include plastic, ceramic, sintered metal, or any combination thereof. These materials can be selected to be permeable to a fluid and may form at least part of a pipe, tube, or other surface through which the fluid may be provided to a volume, such as in a lithography apparatus.

The system may be configured to be pressurised at from around 0.1 bara to around 10 bara, optionally from around 0.5 bara to around 5 bara, preferably around 1 bara. In embodiments in which the system is providing a fluid to a volume which is at near vacuum, the pressure difference across the fluid-permeable surface will be approximately the difference in pressure between the two faces of the fluid-permeable surface. Since the pressure differential can be controlled, the rate of permeation of the fluid can also be controlled.

The fluid is preferably nitrogen-free. In other words, the fluid does not include nitrogen gas. Under certain conditions, nitrogen gas can result in damage to optical elements within a lithography apparatus. As such, in cases where nitrogen gas poses a risk to any components within an apparatus to which the fluid dispensing system is providing fluid, it is preferable to manage this risk by providing nitrogen-free gas. It will be appreciated that by nitrogen-free, it is understood that no nitrogen gas is intentionally included, but trace amounts that are functionally irrelevant may still be present.

The system may be configured to provide fluid at a rate of from around 1 × 10⁻³ to around 1 × 10⁻⁸ mbar^{∗}1/s/cm², preferably from around 1 × 10⁻⁴ to around 1 × 10⁻⁷ mbar^{∗}1/s/cm², preferably from around 1 × 10⁻⁵ mbar^{∗}1/s/cm² to around 1 × 10⁻⁶ mbar^{∗}1/s/cm².

The system may be configured to provide fluid at a flow rate of from around 1 × 10⁻³ to around 1 × 10⁻⁷ mbar*l/s, preferably from around 1 × 10⁻⁴ to around 1 × 10⁻⁶ mbar^{∗}1/s, preferably around 1 × 10⁻⁵ mbar^{∗}1/s.

The system may include a pump configured to control the pressure of the fluid and/or a pressure regulator configured to control the pressure of the fluid. The present disclosure is not particularly limited by the exact way in which the pressure of the fluid is controlled and any means by which the pressure of the fluid can be controlled could be employed.

The system may include a movement mechanism configured to move the fluid-permeable surface relative to a volume to which fluid is to be dispensed and/or to move a non-permeable shield over at least a portion of the fluid-permeable surface in order to control the rate of permeation of the fluid into the volume. In essence, the effective change in the surface area through which fluid can be provided controls how much of the fluid is provided to the volume in a given time period. For example, where the fluid-permeable surface is part of a pipe or tube, the length of the pipe within the volume can be adjusted in order to adjust the rate at which fluid is provided to the volume. As an example, where a greater amount of fluid is required, the pipe can be moved so that there is a longer length of pipe in fluid communication with the volume. Similarly, if less fluid is required, the pipe could be moved such that there is a shorter length of pipe in fluid communication with the volume. It is also possible to reduce the exposed area of the fluid-permeable surface by covering a portion of the surface with a non-permeable shield. As such, although the total surface area of the fluid-permeable surface within the volume to which fluid is to be provided is unchanged, the effective area is controlled by controlling the exposed area of the fluid-permeable surface.

According to a second aspect of the present disclosure, there is provided a method of controlling the dispensing a fluid, the method including: a) providing a fluid-permeable surface having a pre-defined permeability, b) providing a fluid in contact with the fluid-permeable surface, c) controlling one or both of the pressure of the fluid and the exposed surface area of the fluid-permeable surface to control the rate of permeation of the fluid into a volume through the fluid-permeable surface.

By providing a fluid in contact with fluid-permeable surface and then adjusting the pressure of the fluid and/or the surface area through which fluid can permeate, it is possible to provide small amounts of a fluid into a volume, such as within a lithography apparatus. Previously, the fluid would need to be diluted with a carrier gas, which is undesirable.

The method may include controlling the exposed surface area of the fluid-permeable surface by altering one or both of a length of piping or tubing comprising the fluid-permeable surface, and at least partially reversibly covering the fluid-permeable surface with a non-permeable material. As described in respect of the first aspect of the present disclosure, the surface area of the fluid-permeable surface can be adjusted to adjust the rate at which fluid can permeate through the fluid-permeable surface into a volume in a given time. This is because, all else being unchanged, the rate at which fluid permeates through material comprising the surface per unit area is unchanged, so by providing a larger area, the total amount of fluid provided per unit time is increased. Additionally or alternatively, by covering a portion of the fluid-permeable surface with a non-permeable surface, the surface area through which fluid can permeate is reduced.

The method may include providing a fluid selected from air, oxygen, a nitrogen oxide, hydrogen, helium, a carbon oxide, neon, argon, and water, or any combination thereof. Preferably, the fluid is nitrogen-free.

According to a third aspect of the present disclosure, there is provided a plasma-generating apparatus including the fluid dispensing system according to the first aspect of the present disclosure.

Although specific reference is made to lithography, particularly EUV lithography, apparatuses herein, the present disclosure can also be applied to any other systems in which it is necessary to provide small amounts of fluid that cannot otherwise be provided by existing mechanical means, such as mass flow controllers or simply injection of the fluid, or provided by diluting the fluid of interest with a carrier fluid.

Such apparatuses may be selected from a lithography apparatus, a plasma etching apparatus, a laser, and a fusion reactor. Preferably, the apparatus is an EUV lithography apparatus. Each of these apparatuses defined an internal volume comprising a gas and it is desirable to be able to provide gases in small amounts in the volume. As described herein, due to the low volumes involved, existing means for providing such small amounts of fluid do not allow for the provision of pure fluid and the only way this can be achieved is to dilute the fluid with a carrier fluid, which is undesirable, particularly where the volume is operated under low pressure.

According to a fourth aspect of the present invention, there is provided the use of a fluid dispensing system according to the first aspect of the present disclosure, a method according to the second aspect of the present disclosure, or a plasma-generating apparatus according to the third aspect of the present disclosure in a lithography apparatus or process, preferably an EUV lithography apparatus or process.

It will be appreciated that features described in respect of one embodiment may be combined with any features described in respect of another embodiment and all such combinations are expressly considered and disclosed herein.

### BRIEF DESCRIPTION OF THE DRAWINGS

Embodiments of the invention will now be described, by way of example only, with reference to the accompanying schematic drawing in which corresponding reference symbols indicate corresponding parts, and in which:
Figure 1 depicts a lithographic apparatus according to an embodiment of the invention;
Figure 2 is a schematic depiction of an apparatus according to an embodiment of the invention; and
Figure 3 is a schematic depiction of an apparatus according to an embodiment of the invention.

The features and advantages of the present invention will become more apparent from the detailed description set forth below when taken in conjunction with the drawings, in which like reference characters identify corresponding elements throughout. In the drawings, like reference numbers generally indicate identical, functionally similar, and/or structurally similar elements.

### DETAILED DESCRIPTION

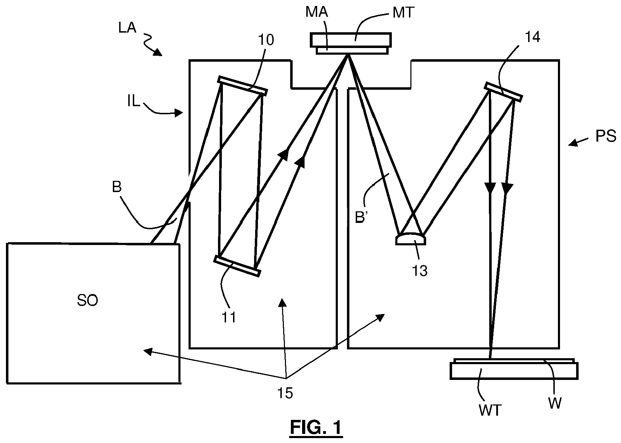

Figure 1 shows an exemplary lithographic system including a fluid dispensing system 15 (according to the present invention. It will be appreciated that the present invention is not limited to only lithographic systems, but finds particular application thereto. It will also be appreciated that more than one fluid dispensing system 15 may be provided as required. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA (e.g. a mask), a projection system PS and a substrate table WT configured to support a substrate W. The illumination system IL is configured to condition the radiation beam B before it is incident upon the patterning device MA. The projection system is configured to project the radiation beam B (now patterned by the mask MA) onto the substrate W. The substrate W may include previously formed patterns. Where this is the case, the lithographic apparatus aligns the patterned radiation beam B with a pattern previously formed on the substrate W. In this embodiment, the exact position of the fluid dispensing system 15 is not provided and it will be appreciated that the fluid dispensing system 15 may be located in any required position.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type which may be referred to as a laser produced plasma (LPP) source. A laser, which may for example be a CO₂ laser, is arranged to deposit energy via a laser beam into a fuel, such as tin (Sn) which is provided from a fuel emitter. Although tin is referred to in the following description, any suitable fuel may be used. The fuel may for example be in liquid form, and may for example be a metal or alloy. The fuel emitter may comprise a nozzle configured to direct tin, e.g. in the form of droplets, along a trajectory towards a plasma formation region. The laser beam is incident upon the tin at the plasma formation region. The deposition of laser energy into the tin creates a plasma at the plasma formation region. Radiation, including EUV radiation, is emitted from the plasma during de-excitation and recombination of ions of the plasma.

The EUV radiation is collected and focused by a near normal incidence radiation collector (sometimes referred to more generally as a normal incidence radiation collector). The collector may have a multilayer structure which is arranged to reflect EUV radiation (e.g. EUV radiation having a desired wavelength such as 13.5 nm). The collector may have an elliptical configuration, having two ellipse focal points. A first focal point may be at the plasma formation region, and a second focal point may be at an intermediate focus, as discussed below.

The laser may be separated from the radiation source SO. Where this is the case, the laser beam may be passed from the laser to the radiation source SO with the aid of a beam delivery system (not shown) comprising, for example, suitable directing mirrors and/or a beam expander, and/or other optics. The laser and the radiation source SO may together be considered to be a radiation system.

Radiation that is reflected by the collector forms a radiation beam B. The radiation beam B is focused at a point to form an image of the plasma formation region, which acts as a virtual radiation source for the illumination system IL. The point at which the radiation beam B is focused may be referred to as the intermediate focus. The radiation source SO is arranged such that the intermediate focus is located at or near to an opening in an enclosing structure of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 which are configured to project the radiation beam B onto a substrate W held by the substrate table WT. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The radiation sources SO shown in Figure 1 may include components which are not illustrated. For example, a spectral filter may be provided in the radiation source. The spectral filter may be substantially transmissive for EUV radiation but substantially blocking for other wavelengths of radiation such as infrared radiation.

If the patterning device MA is left unprotected, the contamination can require the patterning device MA to be cleaned or discarded. Cleaning the patterning device MA interrupts valuable manufacturing time and discarding the patterning device MA is costly. Replacing the patterning device MA also interrupts valuable manufacturing time. As such, the provision of a small amount of a fluid, such as oxygen, which is less than that which is able to be provided by existing means without the use of a diluting carrier gas, can be provided by the apparatus of the present disclosure. This gas can be used to clean certain elements within the apparatus and/or to mitigate the creation of contaminants.

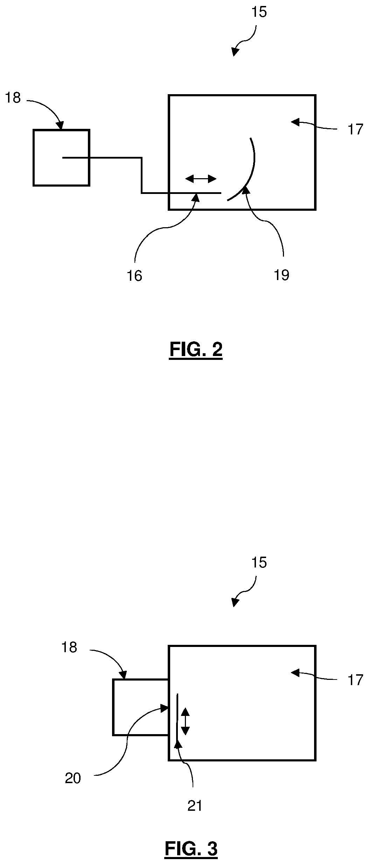

Figure 2 is a schematic depiction of a fluid dispensing system 15 according to the present invention applied to an exemplary volume, which may be, for example an interior of a lithographic apparatus or other plasma-generating device. In the exemplary depiction, a pipe 16 is in fluid connection with a volume 17. As shown by the doubled-headed arrow, the pipe 16 can be moved to alter the length of pipe 16 in fluid communication with the volume 17. In this way, the rate at which a fluid is provided to the volume 17 via permeation through the pipe 16 can be controlled. The pipe 16 is connected to a controller 18. The controller 18 can adjust the extent to which the pipe 16 is in fluid communication with the volume 17 and/or can control the pressure within the pipe 16 to control the rate at which a fluid is provided to the volume 17 via permeation through the pipe 16. Although depicted as a linear pipe, the pipe 16 can be of any shape, and may, for example, be coiled. The pipe 16 is also depicted as being a dead-end, but it will be appreciated that it could pass into and then out of the volume 17 if required., such as in the form of one or more loops. Although not shown, it will be understood that a shield may be provide which covers at least a portion of the pipe 16 within the volume 17, thereby controlling the effective length (i.e. the length of pipe 16 which is able to provide fluid therefrom to the volume 17) of the pipe 16 within the volume 17. In the depicted embodiment, the pipe 17 is located close to a mirror 19 such that the fluid provided by the pipe 17 is provided close to where it is needed. Again, the present disclosure is not particularly limited to providing a fluid to a mirror and indeed it is possible to operate the present disclosure in any volume which requires the addition of smal amounts of a fluid. The volume can be any enclosed area which requires the controlled addition of small amounts of a fluid that cannot be achieved by existing control systems.

Figure 3 depicts an embodiment in which the fluid-permeable surface 20 is provided in a wall of the volume 17. A controller 18 is in communication with the fluid-permeable surface 20 such that the rate of fluid permeation into the volume 17 is controlled. As previously discussed, this could be done by varying the pressure and/or exposed surface area of the fluid-permeable surface 20. In order to vary the exposed surface area of the fluid-permeable surface 20, a shield 21 may be provided. The double-headed arrow depicts the shield 21 moving to expose more or less of the fluid-permeable surface 20 in order to control the rate at which fluid is provided to the volume 17. The shield 21 can be of any construction so long as it reduces the rate at which fluid can enter the volume 17. For example, the shield 21 could be in the form of an iris that is opened or closed to vary the exposed surface area of the fluid-permeable surface 20.

In summary, the present disclosure provides for the provision of very small amounts of a fluid into a volume where previously the fluid of interest would need to be diluted with a carrier gas due to limitations of existing control systems. The present disclosure thereby also avoids the need to add additional volumes of a carrier gas to the system to which fluid is being supplied. The present disclosure also allows for the fluid to be provided in the vicinity of where it is desired.

While specific embodiments of the invention have been described above, it will be appreciated that the invention may be practiced otherwise than as described.

The descriptions above are intended to be illustrative, not limiting. Thus it will be apparent to one skilled in the art that modifications may be made to the invention as described without departing from the scope of the claims set out below.

## Claims

1. A fluid dispensing system including a fluid-permeable surface having a pre-defined permeability to allow permeation of a fluid, and a controller configured to control the rate of permeation of the fluid into a volume by controlling one or both of a pressure of the fluid and an exposed surface area of the fluid-permeable surface.

2. The fluid dispensing system according to claim 1, wherein the fluid-permeable surface is defined by a pipe or tube.

3. The fluid dispensing system according to claim 1 or claim 2, wherein the fluid is selected from air, oxygen, a nitrogen oxide, hydrogen, helium, a carbon oxide, neon, argon, and water, or any combination thereof.

4. The fluid dispensing system according to any preceding claim, wherein the fluid-permeable surface comprises plastic, ceramic, or sintered metal.

5. The fluid dispensing system according to any preceding claim, wherein the system is configured to be pressurised at from around 0.1 bar to around 10 bara, optionally from around 0.5 bara to around 5 bara, preferably around 1 bara.

6. The fluid dispensing system according to any preceding claim, wherein the fluid is nitrogen-free.

7. The fluid dispensing system according to any preceding claim, wherein the system is configured to provide fluid at a rate of from around 1 × 10⁻³ to around 1 × 10⁻⁸ mbar^{∗}1/s/cm², preferably from around 1 × 10⁻⁴ to around 1 × 10⁻⁷ mbar^{∗}1/s/cm², preferably from around 1 × 10⁻⁵ mbar^{∗}1/s/cm² to around 1 × 10⁻⁶ mbar^{∗}1/s/cm².

8. The fluid dispensing system according to any preceding claim, wherein the system is configured to provide fluid at a flow rate of from around 1 × 10⁻³ to around 1 × 10⁻⁷ mbar^{∗}1/s, preferably from around 1 × 10⁻⁴ to around 1 × 10⁻⁶ mbar^{∗}1/s, preferably around 1 × 10⁻⁵ mbar^{∗}1/s.

9. The fluid dispensing system according to any preceding claim, wherein the system includes a pump configured to control the pressure of the fluid and/or a pressure regulator configured to control the pressure of the fluid.

10. The fluid dispensing system according to any preceding claims, wherein the system includes a movement mechanism configured to move the fluid-permeable surface relative to a volume to which fluid is to be dispensed and/or to move a non-permeable shield over at least a portion of the fluid-permeable surface in order to control the rate of permeation of the fluid into the volume.

11. A method of controlling the dispensing a fluid, the method including:
a) providing a fluid-permeable surface having a pre-defined permeability,
b) providing a fluid in contact with the fluid-permeable surface,
c) controlling one or both of the pressure of the fluid and the exposed surface area of the fluid-permeable surface to control the rate of permeation of the fluid into a volume through the fluid-permeable surface.

12. The method according to claim 9, wherein the exposed surface area of the fluid-permeable surface is controlled by one or both of altering a length of piping or tubing comprising the fluid-permeable surface, and at least partially reversibly covering the fluid-permeable surface with a non fluid-permeable material.

13. The method according to any of claims 11 or 12, wherein providing a fluid in contact with the fluid-permeable membrane includes providing from air, oxygen, a nitrogen oxide, hydrogen, helium, a carbon oxide, neon, argon, and water, or any combination thereof, preferably wherein the fluid is nitrogen-free.

14. A plasma-generating apparatus including the fluid dispensing system according to any of Claims 1 to 10.

15. The plasma-generating apparatus of claim 14, wherein the apparatus is selected from a lithography apparatus, a plasma etching apparatus, a laser, and a fusion reactor, preferably an EUV lithography apparatus.

16. The use of the fluid dispensing system of claims 1 to 10, the method of claims 11to 13, or the plasma-generating apparatus of claims 14 or 15 in a lithography apparatus or process, preferably an EUV lithography apparatus or process.
